# EUROPEAN PATENT SPECIFICATION

(11) **EP 1 160 970 B1**
(45) Date of publication and mention of the grant of the patent: **27.12.2006**
(21) Application number: 00111507.0
(22) Date of filing: 29.05.2000
(51) Int. Cl.: H03D 1/04

(54) **Interference suppresser for AM signals , and method**
Schaltung zur Unterdrückung von Interferenzsignalen bei AM Signalen , und Verfahren dazu
Dispositif de suppression d'interférences pour signaux AM , et procédé

(43) Date of publication of application: 05.12.2001
(73) Proprietor: Sony Deutschland GmbH, 50829 Köln (DE)
(72) Inventor: Wildhagen, Jens, c/o Advanced Technology Center, 70327 Stuttgart (DE); Nöthlings, Rolf, c/o Advanced Technology Center, 70327 Stuttgart (DE)
(74) Representative: Müller - Hoffmann & Partner

(56) References cited:
- EP-A- 0 898 402
- GB-A- 2 250 877
- US-A- 4 255 791
- US-A- 5 955 987

## Description

The present invention relates to the suppression of distortions in an AM signal, in particular to the suppression of interferers, i. e. single sinus tones, caused by other technical devices or by distortion carriers from other transmitters, or other narrow band distortions.

Generally, in AM broadcasting signals are often disturbed by interferers which can be caused by other technical devices located more or less close to the receiver, e. g. a monitor which might behave as a transmitter in certain frequency ranges located close to the receiver can lead to heavy distortions.

A method to detect such distortions in AM signals is described in the parallel European Patent Application of the Applicant "Detection of distortions in AM signals".

Further, in EP 0 898 402 A2, a detection circuit for ASK or OOK modulation is described, in which the received modulated signal is ac coupled to a dc restoration circuit and amplified thereafter. The dc restoration is carried out on signal peaks corresponding to "mark" intervals of the modulated signal.

It is the object underlying the present invention to provide an uncomplicated method to suppress such detected distortions in an AM signal without any loss of information.

This object is solved by the method defined in independent claim 1. A preferred embodiment thereof is defined in dependent claim 2. A distortion canceller is defined in independent claim 3. Preferred embodiments thereof are defined in the following dependent claims 4 to 8.

According to the present invention the redundancy in the two sidebands of a double sideband AM signal is used to suppress distortions without any loss of information. In the distorted sideband an interferer is suppressed by a bandstop filter removing the subband of the distorted sideband which comprises said interferer and in the undistorted sideband the complementary filter is used to amplify the corresponding subband by the factor of two to be able to suppress the interferer while compensating the information loss by adding both filtered sidebands.

This adding of both sidebands also yields a better signal to noise ratio (SNR) of the resulting signal, since both sidebands usually comprise uncorrellated white noise. To compensate the doubled amplitude of the filtered demodulated AM signal a multiplier with a multiplication factor of 0.5 might be arranged after the filter.

To be able to suppress all distortions within a received AM signal in this way the filter according to the present invention preferably comprises a first narrow band subfilter for every selected subband having a stop band in the frequency range of one disturbed subband and a passband in the frequency ranges of all other subbands and second narrow band subfilter for every selected subband having an amplification by the factor 2 in the frequency range corresponding to that of the one disturbed subband of the disturbed sideband and a passband in the frequency ranges for all other subbands.

Therewith, while removing all distortions with a respective first narrow band subfilter and a corresponding amplification of the respectively corresponding undistorted subband within the other sideband with a multiplication factor 2 all distortions within both sidebands which occur in only one corresponding subband of both sidebands can be removed without information loss.

According to the first preferred embodiment of the distortion canceller according to the present invention each first narrow band subfilter comprises a first notch filter receiving the disturbed sideband and an information which subband thereof should be suppressed to derive a filtered disturbed sideband, and each second narrow band subfilter comprises a second notch filter receiving the undisturbed sideband and information which subband of the disturbed sideband should be suppressed to suppress the corresponding subband of the undisturbed sideband, an amplifier with an amplification factor of two receiving the undisturbed sideband and an adder subtracting the output signal of said second notch filter from the output signal of said amplifier to derive a compensating undisturbed sideband. Preferably, said adder further adds the filtered disturbed sideband to the compensating undisturbed sideband to derive a distortion-free demodulated AM signal without information loss.

According to a second preferred embodiment of the present invention said first narrow band subfilter comprises a highpass filter with a narrow stopband range and a first complex multiplier preceding said highpass filter and frequency shifting the disturbed subband of the complex demodulated AM signal into the narrow stopband range thereof, and said second narrow band subfilter comprises an complementary filter with a narrow band range which amplifies the input signal by a factor of two, a second complex multiplier preceding said complementary filter and shifting the subband of the undisturbed sideband corresponding to the disturbed subband of the once frequency shifted complex demodulated AM signal into the narrow *"multiplication by two"* band range thereof, and a third complex multiplier compensating the frequency shifts of the first and second complex multipliers.

The present invention and its embodiments will be better understood from a detailed description of two exemplary embodiments thereof described in conjunction with the accompanying drawings, wherein
- **Fig. 1**: shows an undisturbed double sideband AM signal;
- **Fig. 2**: shows a double sideband AM signal which is disturbed by two interferers;
- **Fig. 3**: shows the transfer function of the interferer suppression filter without information loss according to the present invention;
- **Fig. 4**: shows a block diagram of an interferer suppression filter without information loss according to a first preferred embodiment of the present invention; and
- **Fig. 5**: shows a block diagram of an interferer suppression filter without information loss according to a second preferred embodiment of the present invention.

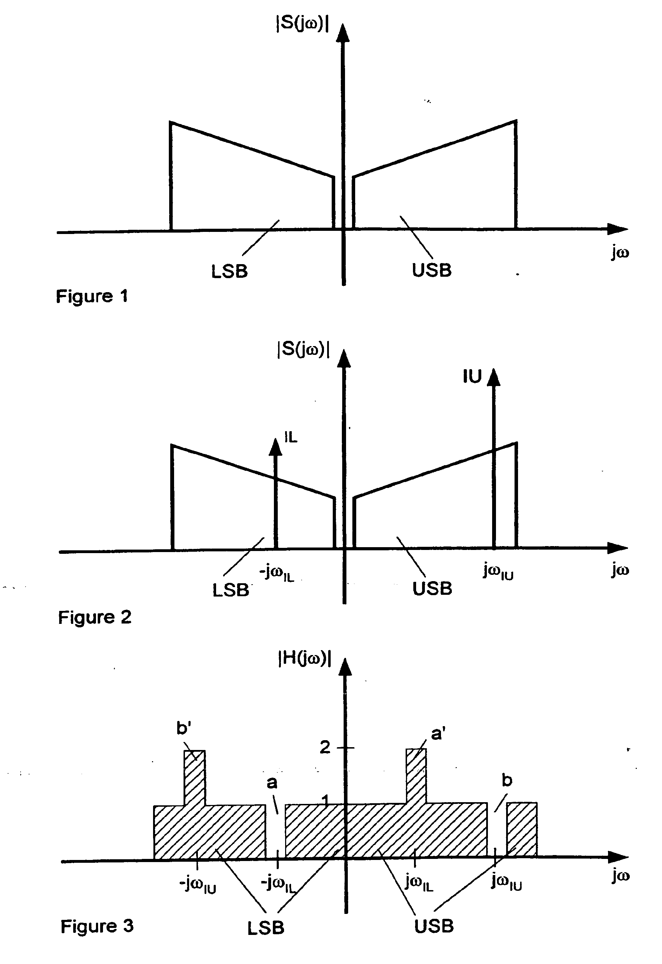

Fig. 1 shows an undisturbed double sideband AM signal which consists of two sidebands containing the same information, namely the lower sideband LSB and the upper sideband USB. The absolute value of the spectrum | S(jω) | of the lower sideband LSB and the upper sideband USB is symmetrical, i. e. the absolute value of the spectrum of a negative frequency -jω of the lower sideband LSB which covers the negative frequencies is equal to the absolute value of the spectrum of the same positive frequency +jω of the upper sideband USB which covers the positive frequencies.

Interferers which result from single sinus tones caused by other technical devices or by distortion carriers from other transmitters usually appear in only one sideband. Fig. 2 shows a complex baseband signal with one interferer IL in the lower sideband LSB and one interferer IU in the upper sideband USB. Both interferers appear as a peak in the spectrum of the complex baseband signal, since they represent a single sinus tone, respectively. The grade of interference is dependent on the amplitude of the respective peak, i. e. on the absolute value of the spectrum |S(jω)| at the respective frequency jω of the interferer. In the shown example the interferer IL within the lower sideband LSB has a smaller amplitude than the interferer IU in the upper sideband USB.

The present invention takes advantage of the fact that the two sidebands in AM broadcasting contain the same information, i. e. a redundancy is given. Therefore, once such distortions are detected and respective subbands comprising said distortions are known, which subbands preferably are as narrow as possible, i. e. might comprise more or less only the frequency of the interferer, it is possible to suppress the interferer in the disturbed sideband and to amplify the corresponding part of the undisturbed sideband by two to be able to compensate the information loss.

Fig. 3 shows the transfer function of a filter used according to the present invention to be able to suppress the distortions shown in Fig. 2 without any information loss. Basically, the transfer function |H(jω)| is designed to have a passband for the lower sideband LSB and the upper sideband USB, i. e. an amplification factor 1 over the whole frequency range of both sidebands. However, since the lower sideband LSB comprises one interferer IL at the frequency -jω_{IL} the transfer function |H(jω)| comprises a signal part a around said frequency -jω_{IL} having an amplification factor 0 to suppress said interferer IL. Further, since the upper sideband USB comprises an interferer IU at the frequency jω_{IU} the transfer function |H(jω)| comprises a signal part b around the frequency jω_{IU} having an amplification factor 0 to suppress said interferer IU. To compensate this removal of information or energy the redundancy of upper and lower sideband is used. Therefore, the transfer function |H(jω)| of the filter according to the present invention comprises a signal part a' corresponding to the signal part a, but arranged around the frequency jω_{IL} having an amplification factor 2 and a signal part b' corresponding to the signal part b, but arranged around the frequency -jω_{IU} having an amplification factor 2.

When now both sidebands are added together there is no loss of information/energy and additionally a better SNR (signal to noise ratio) is gained, as explained above.

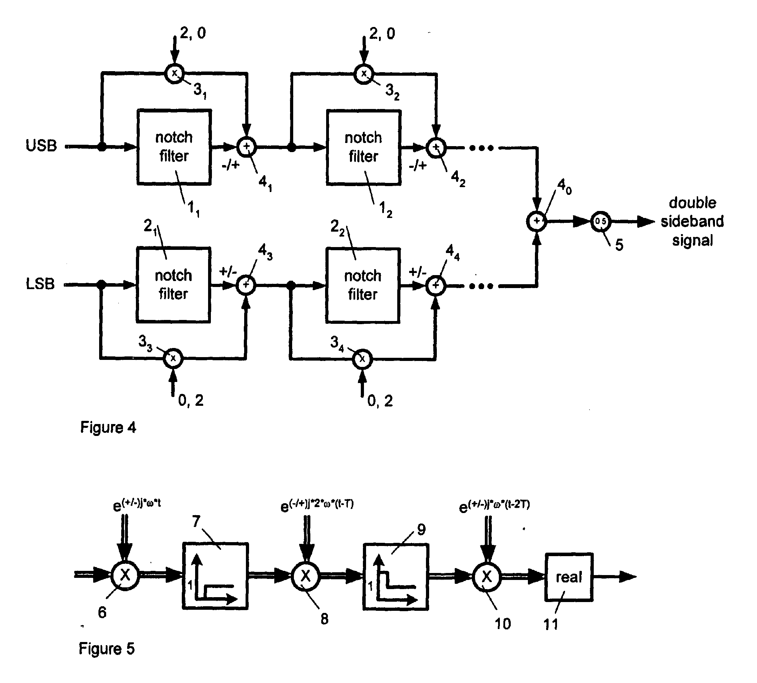

Fig. 4 shows a block diagram of a first preferred embodiment according to the present invention realizing the transfer function H(jω)| for a wanted number of interferers.

Basically, the filtering is performed with notch filters which additionally receive an information at which frequency, i.e. within which subband, an amplification 0 should be applied to the respective input signal. Therefore, in case a single sideband USB, LSB is input to such a notch filter a filtered sideband which does not comprise the respective subband anymore is output therefrom. The other sideband LSB, USB within which the corresponding subband needs an amplification with the factor 2 is input to a further notch filter also applying an amplification 0 to the corresponding subband. The output signal of this further notch filter is subtracted from its amplitude doubled input signal so that in total a filtered sideband which comprises an amplitude doubled corresponding subband is output therefrom. Several such stages of notch filter and further notch filter might be serially connected to filter more that one interferer before the filtered sidebands USB, LSB are added and multiplied by 0.5 to compensate the doubled amplitudefrom the addition of both sidebands.

Fig. 4 shows a realization for the suppression of two interferers, but the expansion to a bigger number of interferers is indicated. The upper sideband USB is input to a first notch filter 1₁ and to a first multiplier 3₁. Based upon the information whether the subband which is removed from the input signal of the first notch filter 1₁ comprises an interferer or is the corresponding undisturbed subband of the other sideband the first multiplier 3₁ multiplies its input signal by 0 or by 2. Further, based on this information the output signal of the first notch filter 1₁ is added to or subtracted from the output signal of the first multiplier 3₁ by a first adder 4₁. Similar, the lower sideband LSB is input to a second notch filter 2₁ and to a second multiplier 3₃ which are basically working similar to the first notch filter 1₁ and the first multiplier 3₁, i.e. the second notch filter 2₁ suppresses the subband of the lower sideband corresponding to that of the upper sideband which gets suppressed by the first notch filter 1₁. However, since only one of the subbands comprises an interferer and the other one compensates the information loss which would occur in case only the distorted subband would be suppressed, the second multiplier 3₃ multiplies its input signal by 2 or by 0 depending upon the information whether the subband which is removed from the input signal of the second notch filter 2₁ is the corresponding undisturbed subband of the other sideband or comprises an interferer. Further, based on this information the output signal of the second notch filter 2₁ is subtracted from or added to the output signal of the second multiplier 3₃ by a second adder 4₃. To suppress a second interferer a similar filter stage receives the output signals of the first adder 4₁ and the second adder 4₃ instead of the upper sideband USB and the lower sideband LSB. This further filter stage comprises a third notch filter 1₂, a third multiplier 3₂ and a third adder 4₂ filtering the filtered upper sideband USB as well as a fourth notch filter 2₂, a fourth multilier 3₄ and a fourth adder 4₄ filtering the filtered lower sideband signal. Further such filter stages respectively sensitive to another variable subband might be serially connected as indicated by dots in Fig. 4. The filtered upper sideband USB and lower sideband LSB are finally added by an adder 4₀. The output signal of the adder 4₀ is multiplied by a factor 0.5 by a multiplier 5 to compensate the doubled amplitude of the distortion-free demodulated AM signal without information loss.

The two single sideband signals are real-valued and the transfer functions of the different filters are real-valued functions as well. The notch filters are bandstop filters with adjustable center frequency.

Fig. 5 shows the realization of the filter according to a second preferred embodiment of the invention. In this case the complex double sideband baseband signal is filtered and two filters are used, namely a highpass filter and its complementary filter. To filter the right frequency ranges the signal is shifted via a complex multiplication in front of the respective filter. A third complex multiplication after the filtering compensates both complex multiplications in front of a respective filter. In this case a serial connection of several of these arrangements leads to the possibility to suppress more than one interferer without information/energy loss.

Fig. 5 shows that the complex double sideband baseband signal is shifted by a first complex multiplier 6 so that a disturbed frequency ω is shifted to the low frequency range by a complex multiplication with the factor e^{(+/-)jωt} wherein the sign in the complex argument depends on which sideband is distorted, i.e. shows whether the frequency ω is positive or negative. This frequency shifted complex double sideband baseband signal is filtered by a highpass filter 7 so that the distortion which is shifted to the low frequency range, i. e. which has the frequency 0, is removed from the signal and the rest of the signal remains unchanged. A following frequency shift by way of a complex multiplication in a second complex multiplier 8 with the multiplication factor e^{(+/-)j2ωt} shifts the frequency of the undisturbed sideband corresponding to the frequency of the interferer in the disturbed sideband to the low frequency range, i. e. to a frequency 0. A following complementary filter 9 having an amplification of 2 in the low frequency range corresponding to the stopband of the highpass filter 7 and of 1 in the high frequency range corresponding to the passband of the highpass filter 7 generates a compensation for the removed distortion. A following third muliplication with a third complex multiplier 10 by a multiplication factor e^{(+/-)jωt} compensates the first two frequency shifts before the filtered complex double sideband baseband signal is converted into a real signal by a conversion stage 11. To provide the correct phase at the output of the third complex multiplier 10 the group delay T of the highpass filter 7 and of the complementary filter 9 is considered during at least one of the complex multiplications, e.g. those performed by the second complex multiplier 8 and the third complex multiplier 10.

The complex input signal has to be coherent to yield a linear frequency response of the AM signal.

As mentioned above, by using a cascade of these filter realizations more than one interferer, even if they are distributed in both sidebands, can be suppressed.

## Claims

1. Method to suppress distortions in an AM signal, **characterized by** suppressing at least one subband with a small bandwidth with respect to the bandwidth of a sideband comprising a distortion in one sideband and by amplifying the corresponding subband in the other sideband before adding both sidebands.

2. Method according to claim 1, **characterized by** the following steps:
- receiving an information of which subband of which sideband of the received AM signal is disturbed and comprises the at least one distortion to be suppressed,
- filtering the disturbed sideband with a narrow band filter having a stop band in the frequency range of the at least one disturbed subband and a passband in the frequency ranges of all other subbands, and
- filtering the undisturbed sideband with a narrow band filter having an amplification by the factor two in the frequency range corresponding to that of the at least one disturbed subband of the disturbed sideband and a passband in the frequency ranges of all other subbands.

3. Distortion canceller to suppress distortions in an AM signal, **characterized by** a filter to suppress selected disturbed subbands with a small bandwidth with respect to the bandwidth of a sideband comprising a distortion in one sideband of the received AM signal and to amplify the corresponding subbands in the other sideband before both sidebands are added.

4. Distortion canceller according to claim 3, **characterized by**
- a first narrow band subfilter (1₁, 3₁, 4₁; 7) for every seleced disturbed subband having a stop band in the frequency range of the selected disturbed subband and a passband in the frequency ranges of all other subbands, and
- a second narrow band subfilter (2₁, 3₃, 4₃; 9) for every corresponding subband having an amplification by the factor two in the frequency range of the corresponding subband in said other sideband and a passband in the frequency ranges of all other subbands.

5. Distortion canceller according to claim 4, **characterized in that**
- said first narrow band subfilter comprises a first notch filter (1) receiving said one sideband and an information of which subband thereof should be suppressed to derive a filtered disturbed sideband, and
- said second narrow band subfilter comprises a second notch (2) filter receiving said other sideband and an information of which subband of said one sideband should be suppressed to suppress the corresponding subband of said other sideband, an amplifier (3) with an amplification factor of two receiving said other sideband and an adder (4) subtracting the output signal of said second notch filter from the output signal of said amplifier to derive a compensating undisturbed sideband.

6. Distortion canceller according to claim 5, **characterized in that** said adder (4) further adds the filtered disturbed sideband to the compensating undisturbed sideband to derive a distortion-free demodulated AM signal without information loss.

7. Distortion canceller according to claim 6, **characterized by** a multiplier (5) with a multiplication factor of 0.5 arranged after said adder (4) to compensate the doubled amplitude of the distortion-free demodulated AM signal without information loss.

8. Distortion canceller according to claim 4, **characterized in that**
- said first narrow band subfilter comprises a highpass filter (7) with a narrow stopband range and a first complex multiplier (6) preceding said highpass filter (7) and frequency shifting the disturbed subband of said one sideband of the complex demodulated AM signal into the narrow stopband range thereof, and
- said second narrow band subfilter comprises a complementary filter (9) with a narrow multiplication by two band range, a second complex multiplier (8) preceding said complementary filter (9) and shifting the corresponding subband of said other sideband corresponding to the disturbed subband of the once frequency shifted complex AM signal into the narrow multiplication by two band range thereof, and third complex multiplier (10) compensating the frequency shifts of the first and second complex multipliers.

## Patentansprüche

1. Verfahren zum Unterdrücken von Verzerrungen in einem AM Signal, **dadurch gekennzeichnet, dass** wenigstens ein Subband mit einer Verzerrung in einem Seitenband und einer schmalen Bandbreite in Bezug auf die Bandbreite eines Seitenbandes unterdrückt wird und das entsprechende Subband in dem anderen Seitenband verstärkt wird, bevor beide Seitenbänder addiert werden.

2. Verfahren nach Anspruch 1, **gekennzeichnet durch** die folgenden Schritte:
- Empfangen von Information darüber, welches Subband welches Seitenbandes des empfangenen AM Signals gestört ist und die wenigstens eine zu unterdrückende Verzerrung aufweist,
- Filtern des gestörten Seitenbandes mit einem Schmalbandfilter mit einer Bandsperre im Frequenzbereich des wenigstens einen gestörten Subbandes und einer Banddurchlässigkeit in den Frequenzbereichen aller anderen Subbänder, und
- Filtern des ungestörten Seitenbandes mittels eines Schmalbandfilters mit einer Verstärkung um einen Faktor von 2 in dem Frequenzbereich, der dem wenigstens einen gestörten Subband des gestörten Seitenbandes entspricht und mit einer Banddurchlässigkeit in den Frequenzbereichen aller anderen Subbänder.

3. Verzerrungsunterdrücker zum Unterdrücken von Verzerrungen in einem AM Signal, **gekennzeichnet durch** einen Filter zum Unterdrücken ausgewählter gestörter Subbänder mit einer Verzerrung in einem Seitenband des empfangenen AM Signals und mit einer schmalen Bandbreite in Bezug auf die Bandbreite eines Seitenbandes und zum Verstärken der entsprechenden Subbänder in dem anderen Seitenband vor dem Addieren beider Seitenbänder.

4. Verzerrungsunterdrücker nach Anspruch 3, **gekennzeichnet durch**
- einen ersten schmalbandigen Subfilter (1₁, 3₁, 4₁; 7) für jedes ausgewählte gestörte Subband mit einer Bandsperre im Frequenzbereichs des ausgewählten gestörten Subbandes und einer Banddurchlässigkeit in den Frequenzbereichen aller anderen Subbänder, und
- einen zweiten schmalbandigen Subfilter (2₁, 3₃, 4₃; 9) für jedes zugehörige Subband mit einer Verstärkung um einen Faktor von 2 in dem Frequenzbereich des jeweiligen Subbandes in dem anderen Seitenband und einer Banddurchlässigkeit in den Frequenzbereichen aller anderen Subbänder.

5. Verzerrungsunterdrücker nach Anspruch 4, **dadurch gekennzeichnet, dass**
- der erste schmalbandige Subfilter einen ersten Notch-Filter (1) enthält, der ein Seitenband sowie eine Information zum zu unterdrückenden Subband zur Ableitung eines gefilterten gestörten Seitenbandes empfängt, und
- der zweite schmalbandige Subfilter einen zweiten Notch-Filter (2) enthält, der das andere Seitenband und eine Information darüber, welches Subband des einen Seitenbandes unterdrückt werden soll, um das entsprechende Subband des anderen Seitenbandes zu unterdrücken, empfängt sowie einen Verstärker (3) mit einem Verstärkungsfaktor von zwei, der das andere Seitenband empfängt, und einen Addierer (4), der das Ausgabesignal des zweiten Notch-Filters von dem Ausgabesignal des Verstärkers zur Ableitung eines kompensierenden störungsfreien Seitenbandes subtrahiert.

6. Verzerrungsunterdrücker nach Anspruch 5, **dadurch gekennzeichnet, dass** der Addierer (4) zusätzlich das gefilterte gestörte Seitenband dem kompensierenden störungsfreien Seitenband zur Ableitung eines verzerrungsfreien demodulierten AM Signals ohne Informationsverlust hinzufügt.

7. Verzerrungsunterdrücker nach Anspruch 6, **gekennzeichnet durch** einen Multiplizierer (5) mit einem Multiplikationsfaktor von 0.5, der nach dem Addierer (4) zur Kompensation der zweifachen Amplitude des verzerrungsfreien demodulierten AM Signals ohne Informationsverlust angeordnet ist.

8. Verzerrungsunterdrücker nach Anspruch 4, **dadurch gekennzeichnet, dass**
- der erste schmalbandige Subfilter einen Hochpassfilter (7) mit einem schmalen Bandsperrbereich aufweist sowie einen dem Hochpassfilter (7) vorgeschalteten ersten komplexen Multiplizierer (6), wobei das gestörte Subband des einen Seitenbandes des komplexen demodulierten AM Signals in dessen schmalen Bandsperrbereich in der Frequenz verschoben wird, und
- der zweite schmalbandige Subfilter einen komplementären Filter (9) mit einem schmalen Bandbereich zur Multiplikation mit zwei aufweist, einen dem komplementären Filter (9) vorgeschalteten zweiten komplexen Multiplizierer (8) enthält und das jeweilige Subband des anderen Seitenbandes entsprechend dem gestörten Subband des einmal in der Frequenz verschobenen komplexen AM Signals in dessen schmalen Bandbereich zur Multiplikation mit zwei verschoben wird, sowie einen dritten komplexen Multiplizierer (10) zur Kompensation der Frequenzverschiebungen der ersten und zweiten komplexen Multiplizierer.

## Revendications

1. Procédé destiné à supprimer des distorsions dans un signal à modulation AM, **caractérisé par** le fait de supprimer au moins une sous-bande présentant une petite largeur de bande par rapport à la largeur de bande d'une bande latérale, comprenant une distorsion dans une bande latérale et par l'amplification de la sous-bande correspondante dans l'autre bande latérale avant d'ajouter les deux bandes latérales.

2. Procédé selon la revendication 1, **caractérisé par** les étapes suivantes consistant à :
- recevoir des informations concernant la sous-bande de la bande latérale du signal à modulation AM reçu qui est perturbée et comprend la au moins une distorsion à supprimer,
- filtrer la bande latérale perturbée avec un filtre à bande étroite présentant une bande coupée dans la plage de fréquences de la au moins sous-bande perturbée et une bande passante dans les plages de fréquences de toutes les autres sous-bandes, et
- filtrer la bande latérale non perturbée avec un filtre à bande étroite présentant une amplification d'un facteur 2 dans la plage de fréquences correspondant à celle de la au moins une sous-bande perturbée de la bande latérale perturbée et une bande passante dans les plages de fréquences de toutes autres sous-bandes.

3. Module d'annulation de distorsion destiné à supprimer des distorsions dans un signal à modulation AM, **caractérisé par** un filtre destiné à supprimer des sous-bandes perturbées sélectionnées présentant une petite largeur de bande par rapport à la largeur de bande d'une bande latérale, comprenant une distorsion dans une bande latérale du signal à modulation AM reçu et destiné à amplifier les sous-bandes correspondantes dans l'autre bande latérale avant que les deux sous-bandes latérales ne soient ajoutées.

4. Module d'annulation de distorsion selon la revendication 3, **caractérisé par**
- un premier sous-filtre à bande étroite (1₁, 3₁, 4₁; 7) pour chaque sous-bande perturbée sélectionnée présentant une bande coupée dans la plage de fréquences de la sous-bande perturbée sélectionnée et une bande passante dans les plages de fréquences de toutes les autres sous-bandes, et
- un second sous-filtre à bande étroite (2₁, 3₃, 4₃ ; 9) pour chaque sous-bande correspondante présentant une amplification d'un facteur 2 dans la plage de fréquences de la sous-bande correspondante dans lesdites autres bandes latérales et une bande passante dans les plages de fréquences de toutes les autres sous-bandes.

5. Module d'annulation de distorsion selon la revendication 4, **caractérisé en ce que**
- ledit premier sous-filtre à bande étroite comprend un premier filtre coupe-bande à bande étroite (1) recevant ladite première bande latérale et des informations concernant laquelle de ses sous-bandes devrait être supprimée pour obtenir une bande latérale perturbée filtrée, et
- ledit second sous-filtre à bande étroite comprend une second filtre coupe-bande à bande étroite (2) recevant ladite autre bande latérale et des informations concernant laquelle des sous-bandes de ladite première bande latérale devrait être supprimée afin de supprimer la sous-bande correspondante de ladite autre latérale, un amplificateur (3) présentant un facteur d'amplification de 2 recevant ladite autre bande latérale et un additionneur (4) soustrayant le signal de sortie dudit second filtre coupe-bande à bande étroite du signal de sortie dudit amplificateur pour obtenir une bande latérale non perturbée de compensation.

6. Module d'annulation de distorsion selon la revendication 5, **caractérisé en ce que** ledit additionneur (4) additionne en outre la bande latérale perturbée filtrée à la bande latérale non perturbée de compensation afin d'obtenir un signal à modulation AM démodulé exempt de distorsion sans perte d'informations.

7. Module d'annulation de distorsion selon la revendication 6, **caractérisé par** le multiplicateur (5) présentant un facteur de multiplication de 0,5 agencé avec ledit additionneur (4) pour compenser l'amplitude doublée du signal à modulation AM démodulé exempt de distorsion sans perte d'informations.

8. Module d'annulation de distorsion selon la revendication 4, **caractérisé en ce que**
- ledit premier sous-filtre à bande étroite comprend un filtre passe-haut (7) présentant un plage de bande coupée étroite et un premier multiplicateur complexe (6) précédent ledit filtre passe-haut (7) et décalant en fréquence la sous-bande perturbée de ladite première bande latérale du signal à modulation AM démodulé complexe dans sa plage de bande coupée étroite, et
- ledit second sous-filtre à bande étroite comprend un filtre complémentaire (9) comprenant une plage à bande étroite à multiplication par deux, un second multiplicateur complexe (8) précédent ledit filtre complémentaire (9) et décalant la sous-bande correspondante de ladite autre bande latérale correspondant à la sous-bande perturbée du signal à modulation AM complexe décalé une fois en fréquence dans la plage à bande étroite à multiplication par deux de celui-ci, et un troisième multiplicateur complexe (10) compensant les décalages en fréquence des premier et second multiplicateurs complexes.
